# EUROPEAN PATENT APPLICATION

(11) **EP 2 469 593 A2**
(43) Date of publication of application: **27.06.2012**
(21) Application number: 11194067.2
(22) Date of filing: 16.12.2011
(51) Int. Cl.: H01L 25/075, F21K 99/00

(54) **Light-emitting device and illumination device using the same**

(30) Priority: 21.12.2010 JP 2010284796
(71) Applicant: Panasonic Electric Works Co., Ltd., Kadoma-shi Osaka 571-8686 (JP)
(72) Inventor: Kiba, Keiji, Osaka (JP)
(74) Representative: Rüger, Barthelt & Abel

(57) **Abstract**

[Object] To make occurrence of luminance unevenness difficult even if a failure or something occurs to a solid-state light-emitting element (LED) in an open mode in a light-emitting device using a plurality of LEDs.

[Means for Settlement] A light-emitting device 1 includes a plurality of LED groups 2G each having a plurality of LEDs 2 arranged proximately and connected in series, the LEDs 2 in each LED group 2G are configured so as to be equal in an inter-element potential difference, and the LED groups 2G are connected in parallel and configured so as to be equal in a potential difference. With this configuration, even if a failure or something occurs to one LED 2 in an open mode, current flows to the other LEDs 2. Due to this, the LED group 2G is not extinguished as a group and luminance unevenness can be suppressed.

## Description

### [Technical Field]

The present invention relates to a light-emitting device using a plurality of solid-state light-emitting elements as a light source and an illumination device using this light-emitting device.

### [Background Art]

A light-emitting diode (hereinafter, "LED") attracts attention as a light source for an illumination device that replaces an incandescent light or a fluorescent light because of being capable of emitting high intensity light at low electric power and longer life. Nevertheless, since a single LED is lower than the fluorescent light in luminous energy, a light-emitting device including a plurality of LEDs is used for an ordinary illumination device using the LEDs as a light source.

There are various methods of connecting a plurality of LED chips. For example, Patent Literature 1 discloses a technique for connecting LED chips in the form of a parallel circuit in an array. With this technique, the chips are arranged apiece and current irregularity resulting from irregularity in chip performance directly influences luminance unevenness of a light-emitting unit of an LED module constituting the parallel circuit. Considering this, there is known a technique for connecting a plurality of LED element groups each including a plurality of series connected LEDs in parallel, and reducing current irregularity among the groups as disclosed in, for example, Patent Literature 2. This technique can reduce the irregularity among the element groups and can be, therefore, expected to reduce the luminance unevenness of the light-emitting unit.

### [Conventional Technique Document]

### [Patent Literatures]

[Patent Literature 1] JPA 2006-295085
[Patent Literature 2] JPA Heisei 9-246602

### [Disclosure of the Invention]

### [Problems to be solved by the Invention]

However, with the technique disclosed in Patent Literature 2, even if the luminance unevenness among the element groups can be suppressed, not only one LED but also the other LEDs are not lit when a failure or something occurs to one LED in an open mode since each element group is configured to connect the elements in series. That is, the entire element group is disadvantageously extinguished.

The present invention has been achieved to solve the problems. It is an object of the present invention to provide a light-emitting device and an illumination device using this light-emitting device capable of preventing LEDs other than one failed LED in an open mode from being extinguished and almost free from luminance unevenness even if a plurality of LEDs are used and a failure or something occurs to one LED in the open mode.

### [Means adapted to solve the Problems]

To solve the problems, a light-emitting device according to the present invention includes a plurality of light-emitting element groups each having a plurality of solid-state light-emitting elements arranged proximately and connected in series, wherein the solid-state light-emitting elements in each of the light-emitting element groups are configured so as to be equal in an inter-element potential difference, and the light-emitting element groups are connected in parallel and configured so as to be equal in a potential difference.

In the light-emitting device, it is preferable that the plurality of light-emitting element groups are arranged in an array and constitutes a light-emitting element array.

In the light-emitting device, it is preferable that the light-emitting element array is arranged annularly.

In the light-emitting device, it is preferable that the light-emitting element array is arranged in a matrix.

It is preferable that the light-emitting device is used in an illumination device.

### [Effect of the Invention]

According to the present invention, the series connected solid-state light-emitting elements in each light-emitting element group are configured so as to be equal in the inter-element potential difference. Even if a failure or something occurs to one solid-state light-emitting element in the open mode, a current flows to the other solid-state light-emitting elements. Due to this, the entire light-emitting element group is not extinguished as a group and it is possible to suppress luminance unevenness.

### [Brief Description of the Drawings]

[Fig.1] Fig. 1 is a top view of a light-emitting device according to a first embodiment of the present invention.
[Fig.2] Fig. 2 is a top view illustrating the other configuration of the light-emitting device according to the first embodiment.
[Fig.3] Fig. 3 is a top view illustrating a modification of the other configuration shown in Fig. 2.
[Fig.4] Fig. 4 is a top view of a light-emitting device according to a second embodiment of the present invention.
[Fig.5] Fig. 5 is a top view of a light-emitting device according to a modification of the second embodiment.
[Fig.6] Fig. 6 is a top view of a light-emitting device according to a third embodiment of the present invention.
[Fig.7] Fig. 7 is a top view illustrating the other configuration of the light-emitting device according to the third embodiment.
[Fig.8] Fig. 8 is a top view of a light-emitting device according to a fourth embodiment of the present invention.
[Fig.9] Fig. 9 is a top view of a light-emitting device according to a fifth embodiment of the present invention.

### [Best Mode for Carrying Out the Invention]

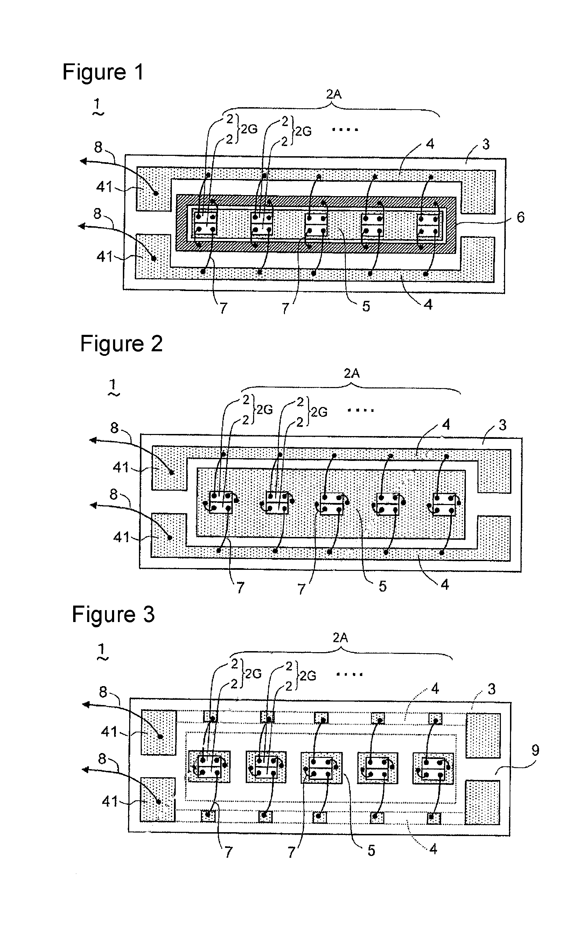

A light-emitting device according to a first embodiment of the present invention will be described referring to Fig. 1. A light-emitting device 1 according to the first embodiment is configured so that a plurality of solid-state light-emitting elements (hereinafter, "LEDs") 2 is arranged on a wiring substrate (hereinafter, "substrate") 3 to be proximate to one another, and includes a plurality of light-emitting element groups (hereinafter, "LED groups") 2G each having the LEDs 2 connected in series. Furthermore, the LED groups 2G are arranged on the substrate 3 in an array and constitute a light-emitting element array (hereinafter, "LED array") 2A. In the first embodiment, the light-emitting device 1 will be described based on an example in which ten LEDs 2 are mounted on the same substrate 3 and in which five LED groups 2G constitute one LED array 2A with each pair arranged proximately to constitute one LED group 2G.

The number of LEDs 2 per substrate 3 is not limited to that in the above-stated example and the number of LEDs 2 arranged proximately is not limited to two. However, it is preferable that the number of LEDs 2 arranged proximately is equal to or smaller than nine so as not to make one LED group 2G too large in size. Moreover, the LEDs 2 within each LED group 2G is arranged to be as proximate as possible preferably at intervals of 1 µm to 0.1 mm. In this case, the number and arrangement of LEDs 2 per LED group 2G are set so that one LED group 2G is closer to a square.

On the substrate 3, a pair of electrode pattern parts 4, a mount pattern part 5 on which a plurality of LEDs 2 is mounted, and an equipotential pattern part 6 surrounding the mount pattern part 5 are patterned. The LEDs 2 are arranged on the mount pattern part 5 and connected in series by bonding wires (hereinafter, "wires") 7 via the equipotential pattern part 6. Further, a positive electrode and a negative electrode of one LED group 2G are connected to the electrode pattern parts 4 by the wires 7, respectively. By doing so, the LEDs 2 in each LED group 2G are configured so as to be equal in an inter-element potential difference and the LED groups 2G are connected in parallel and configured so as to be equal in a potential difference. In the following description, it is assumed that the LED array 2A includes the above-stated pattern parts.

General-purpose nitride semiconductor such as a GaN-based blue LED is preferably used as the LED 2 but emission color (emission wavelength) can be arbitrarily set. In an example shown, the shape of the LED 2 is a rectangle in a top view but the shape is not limited to a specific one and may be a square. In the first embodiment, the LED device 1 will be described based on an example of using top-surface-mounted (so-called face-up) elements in each of which the positive and negative electrodes are provided on a top surface facing a mount surface. However, the type of elements is not limited to this face-up type. For example, a top-bottom electrode type element including positive and negative electrodes on the mount surface and an opposite surface to the mount surface, respectively or a bottom-surface-mounted element having positive and negative electrodes provided only on the mount surface may be used.

As a method of mounting the LEDs 2, the LEDs 2 are bonded on the mount pattern part 5 by a die bonding material (not shown) such as a silicon-based die bonding material and the electrodes on the top surface of each LED 2 are bonded onto the respective electrode pattern parts 4 and the equipotential pattern part 6 by the wires 7. The die bonding material is not limited to the above-stated material and may be, for example, silver paste or high heat resistant epoxy resin material. Furthermore, the patterning and wire bonding method are appropriately changed depending on positions or the like of the electrodes of each LED 2.

As a base material of the substrate 3, a general-purpose insulating material such as glass epoxy resin is used. Alternatively, a ceramic substrate made of alumina, aluminum nitride or the like or a metal substrate having an insulating layer provided on a surface thereof may be used. A shape of the substrate 3 is a long rectangle and a size thereof is, for example, 10 mm × 30 mm × t1.0.

The pattern parts (the electrode pattern parts 4, the mount pattern part 5, and the equipotential pattern part 6) formed on the substrate 3 have, for example, Au surfaces and are formed by plating. The plating is not limited to Au plating but may be, for example, Ag, Cu or Ni plating. Further, Au on the surface of each pattern part may be of a multilayer structure such as Au/Ni/Ag so as to improve bonding power of bonding the pattern part to the substrate 3. Preferably, a light reflection treatment is carried out to the surface of the mount pattern part 5 so that the surface can reflect light emitted from the LED 2 toward the substrate 3.

The electrode pattern parts 4 are formed on longitudinal both edges of the substrate 3, respectively, and an electrode pad 41 for connecting a lead 8 is provided on each of or one of right and left sides of each electrode pattern part 4. Note that the lead 8 is connected to a feeding part (not shown) of the light-emitting device 1 or to the other light-emitting device 1. The mount pattern part 5 is formed into a strip in a central region of the substrate 3. The equipotential pattern 6 is formed to surround the mount pattern part 5 and to be apart from the electrode pattern parts 4 at predetermined distances. The equipotential pattern part 6 suffices to be formed as a continuous pattern and does not necessarily surround the mount pattern part 5. For example, if three or more LEDs 2 constitute one LED group 2G, a plurality of equipotential pattern parts 6 may be formed. In this case, the equipotential pattern parts 6 are formed to be apart from one another so as to ensure mutual insulation, for example, either inside or outside of the equipotential pattern part 6 shown in Fig. 1.

As the wires 7, general-purpose Au wires, for example, are used. Alternatively, A1 wires, Cu wires or the like may be used. The wires 7 are bonded to the electrodes of the LEDs 2 and pattern parts by a well-known bonding method such as thermal bonding or ultrasonic bonding.

When a current is supplied from the feeding part (not shown) via the leads 8 and injected into the LEDs 2 via the electrode patterns 4 and the wires 7, the LEDs 2 emit light. Generally, performance irregularity is present among individual LEDs. Due to this, even if the same voltage is applied to a plurality of LEDs, luminances of the LEDs often do not match. On the other hand, according to the light-emitting device 1 of the first embodiment, the performance irregularity among the LEDs is leveled by causing a plurality of LEDs 2 to emit light as a group of series connected LEDs 2. Furthermore, since a plurality of LED groups 2G are connected in parallel, the potential difference is equal among the LED groups 2G and luminances of the LED groups 2G are made uniform. As a result, the light-emitting device 1 can irradiate light almost free from luminance unevenness. Moreover, even if one of the LEDs 2 fails in the short mode in the LED group 2G, the LED 2 can be lit as long as the other LEDs 2 in the LED group 2G are normal. Therefore, the LED group 2G is not extinguished as a group and the luminance unevenness of the overall light-emitting device 1 can be suppressed.

Furthermore, in the light-emitting device 1 according to the first embodiment, the LEDs 2 are connected in series via the equipotential pattern part 6 and thereby configured so as to be equal in the potential difference in each LED group 2G. With this configuration, after current flows to one LED 2 in the LED group 2G from one of the electrode pattern parts 4 and then flows from this LED 2 to the other LEDs 2 including the LEDs 2 in the other LED groups 2G via the equipotential pattern part 6, the current also flows to the other electrode pattern part 4. Accordingly, even if a failure occurs to one LED 2 provided on the substrate 3 in the open mode, current flows to the remaining LEDs 2 in the LED group 2G including the failed LED 2 from the equipotential pattern part 6. Therefore, the remaining LEDs 2 are lit, whereby the LED group 2G including the failed LED 2 is not extinguished as a group and it is possible to suppress the luminance unevenness of the entire light-emitting device 1. Furthermore, even if a part of the wires 7 is disconnected, a current flows to the respective LEDs 2 by the other wires 7 connected to the equipotential pattern part 6 and those LEDs 2 emit light. It is, therefore, possible to improve reliability of an illumination device into which the light-emitting device 1 is incorporated.

The other configuration of the light-emitting device 1 according to the first embodiment will be described referring to Figs. 2 and 3. As shown in Fig. 2, this configuration is such that the mount pattern part 5 is formed larger and allowed to also function as the above-stated equipotential pattern part 6. In this case, the two wires 7 for electrically connecting the LEDs 2 in each LED group 2G are connected to the mount pattern part 5.

With this configuration, it is possible to form the mount pattern part 5 on the substrate 3 to have a larger area, whereby heat from the LEDs 2 is transmitted to the entire substrate 3 via the mount pattern part 5 and radiation performance can be, therefore, improved. Furthermore, by carrying out a high reflection treatment to this mount pattern part 5, the mount pattern part 5 can reflect light emitted from the LEDs 2 toward the substrate 3 in a light output direction of the light-emitting device 1 and light extraction efficiency can be, therefore, improved.

As shown in Fig. 3, all the pattern parts but regions necessary to connect the wires 7 and to mount the LEDs 2 on the substrate 3 may be covered with a white resist 9. The white resist 9 is formed by, for example, lift-off process. Since the white resist 9 protects the pattern parts, wiring reliability improves. Besides, this facilitates handling the light-emitting device 1 when incorporating the light-emitting device 1 into the illumination device, thereby improving device production efficiency.

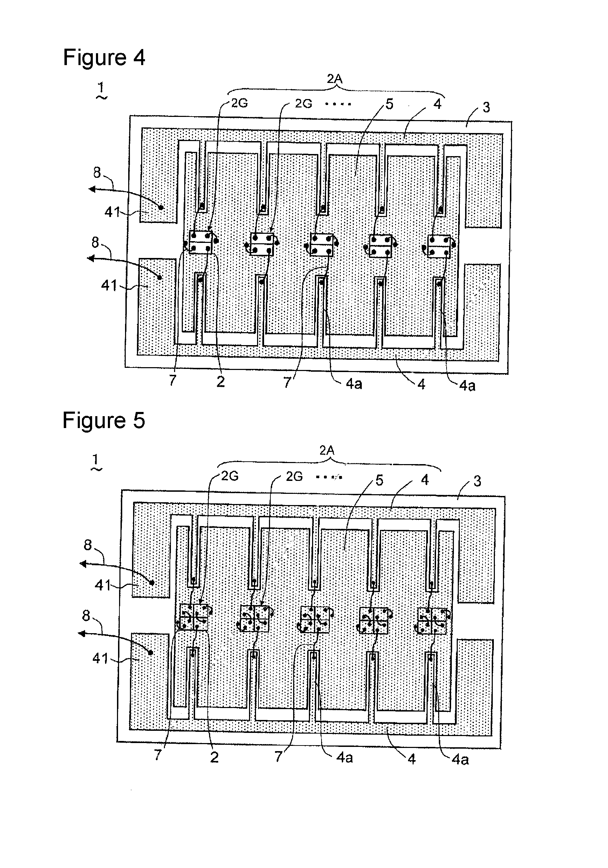

A light-emitting device according to a second embodiment of the present invention will next be described referring to Fig. 4. The light-emitting device 1 according to the second embodiment includes extraction electrode units 4a extending from the electrode pattern parts 4 to the vicinity of the respective LED groups 2G. Furthermore, the mount pattern part 5 is formed to be apart from the electrode pattern parts 4 including the extraction electrode units 4 so as to ensure insulation from the electrode pattern parts 4. Moreover, in the second embodiment, the substrate 3 is wider than that shown in the first embodiment. While the extraction electrode units 4a are preferably extracted up to positions away from mounted positions of the respective LED groups 2A by 0.5 mm to 1.0 mm, positional relation between the extraction electrode units 4a and the LED groups 3G is not limited to the above-stated relation. Each extraction electrode unit 4a suffices to have a width enough to bond the wires 7, preferably a width of 0.5 mm. Tip end portions of the extraction electrode units 4a formed as stated above are electrically connected to the positive and negative electrodes of each LED group 2G by the wires 7, respectively.

With this configuration, the extraction electrode units 4a extend up to the vicinity of the LED groups 2G. Due to this, when the LEDs 2 are wire-bonded to the electrode pattern parts 4, it is possible to decrease the quantity of the wires 7 consumed and reduce production cost. Furthermore, as the connected wires 7 are made shorter, and it is possible to make occurrence of disconnection of the wires 7 less frequent, accordingly and the reliability of the light-emitting device 1 can be improved. Moreover, even if the wider substrate 3 is used, there is no need to increase the quantity of the wires 7 consumed. By using the wider substrate 3, the mount pattern part 5 can be formed to have a larger area. This enables the heat from the LEDs 2 to be transmitted to the entire substrate 3 via the mount pattern part 5 and the radiation performance can be, therefore, improved.

A light-emitting device according to a modification of the second embodiment will next be described referring to Fig. 5. The light-emitting device 1 according to the modification of the second embodiment is configured so that four (2x2) LEDs 2 having square top surfaces are used to constitute one LED group 2G, the four LEDs 2 are connected in series, and so that the second and third LEDs 2 are connected to each other via the mount pattern part 5. With this configuration, even if a failure occurs to one LED 2 in the open mode among the four LEDs 2 included in one LED group 2G, a current is supplied to at least the two LEDs 2 included in the LED group 2G from the equipotential pattern part 6. Due to this, those LEDs 2 are lit, the LED group 2G is not extinguished as a group, and the luminance unevenness of the entire light-emitting device 1 can be suppressed. Furthermore, since the number of LEDs 2 per LED group 2G increases, the entire luminous energy increases and the light-emitting device 1 can be applied to a high power illumination device.

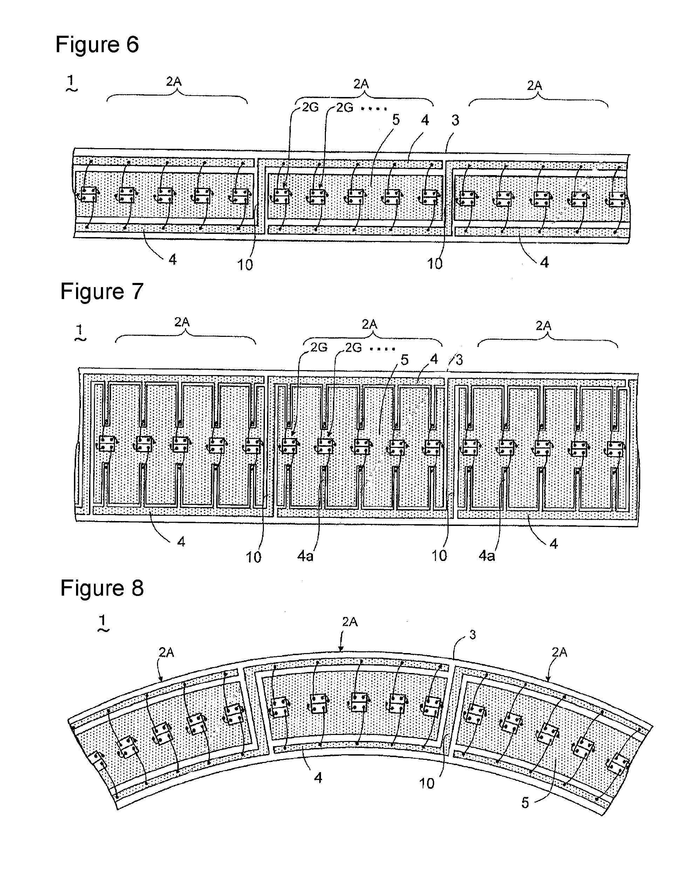

A light-emitting device according to a third embodiment of the present invention will next be described referring to Figs. 6 and 7. As shown in Fig. 6, the light-emitting device 1 according to the third embodiment is configured so that a plurality of LED arrays 2A (each configured as shown in Fig. 2) is further formed in an array on the substrate 3 formed longer than the substrate 3 shown in the first and second embodiments. The electrode pattern parts 4 in the LED arrays 2A are connected to one another via connection pattern parts 10. Each connection pattern part 10 connects the upper electrode pattern part 4 of a certain LED array 2A to the lower electrode pattern part 4 of the LED array 2A on the left of and adjacent to the certain LED array 2A in Fig. 6. Electrode pads are provided on the electrode pattern parts 4 located on both ends of the LED arrays 2A arranged in an array and connected to the feeding part (not shown) via leads or the like. It is preferable that the LED arrays 2A are arranged so that the distance between the two LED groups 2G in one LED array 2A is almost equal to the distance between the LED groups 2G located on ends of the adjacent LED arrays 2A.

With this configuration, even the long light-emitting device 1 that can replace a tubular fluorescent light can irradiate light almost free from luminance unevenness similarly to the first and second embodiments. As shown in Fig. 7, a plurality of LED arrays 2A shown in Fig. 4 may be further formed in an array.

A light-emitting device according to a fourth embodiment of the present invention will next be described referring to Fig. 8. The light-emitting device 1 according to the fourth embodiment is configured so that a plurality of LED arrays 2A is formed on the substrate 3 formed to be annular. Specifically, the electrode pattern parts 4 and the mount pattern part 5 are formed into a circular arch shape according to the annular shape of the substrate 3 and the LED groups 2G are arranged equidistantly on this mount pattern part 5. The other configurations are similar to those according to the third embodiment. With this configuration, even the light-emitting device 1 that can replace an annular fluorescent light can irradiate light almost free from luminance unevenness similarly to the first to third embodiments.

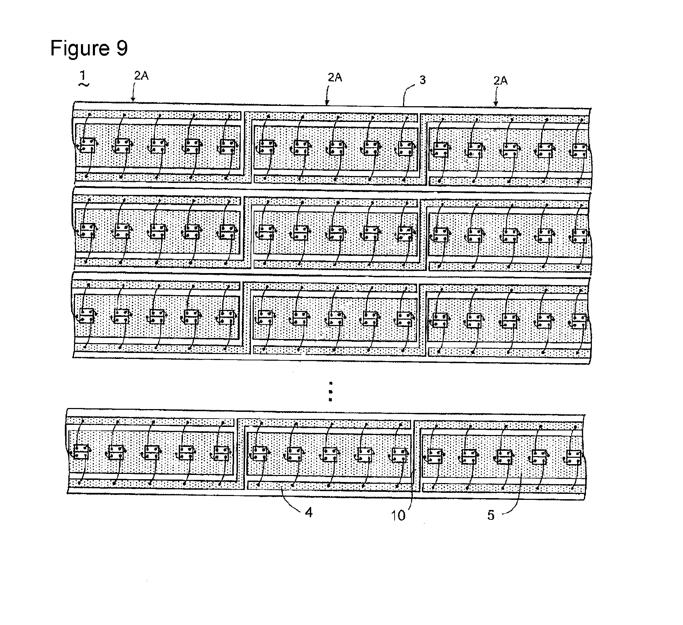

A light-emitting device according to a fifth embodiment of the present invention will next be described referring to Fig. 9. The light-emitting device 1 according to the fifth embodiment is configured so that the LED arrays 2A are arranged in a matrix and corresponds to light-emitting devices 1 each of which is shown in the third embodiment (see Fig. 6) and that are arranged proximately. With this configuration, even the sheet light-emitting device 1 can irradiate light almost free from the luminance unevenness similarly to the first to fourth embodiments. Furthermore, by changing the number of columns of the connected LED arrays 2A, it is possible to manufacture a sheet light source (an illumination device) having an arbitrary size.

The present invention is not limited to the above-stated embodiments and can be variously modified. The light-emitting device 1 configured as stated above is provided with a sealing member, a wavelength conversion member, and the like, further incorporated into an illumination fixture main body, and manufactured as an illumination device.

### [Description of Reference Numerals]

1 Light-emitting device
2 LED (solid-state light-emitting element)
2G LED group (light-emitting element group)
2A LED array (light-emitting element array)

## Claims

1. A light-emitting device comprising a plurality of light-emitting element groups each having a plurality of solid-state light-emitting elements arranged proximately and connected in series, wherein
the solid-state light-emitting elements in each of the light-emitting element groups are configured so as to be equal in an inter-element potential difference, and
the light-emitting element groups are connected in parallel and configured so as to be equal in a potential difference.

2. The light-emitting device according to claim 1, wherein
the plurality of light-emitting element groups is arranged in an array and constitutes a light-emitting element array.

3. The light-emitting device according to claim 2, wherein
the light-emitting element array is arranged annularly.

4. The light-emitting device according to claim 2, wherein
the light-emitting element array is arranged in a matrix.

5. An illumination device using the light-emitting device according to any one of claims 1 to 4.
